Europäisches Patentamt

(19) European Patent Office

Office européen des brevets

(11) Veröffentlichungsnummer : **0 027 544**
**B1**

(12) **EUROPÄISCHE PATENTSCHRIFT**

(45) Veröffentlichungstag der Patentschrift :
24.08.83

(51) Int. Cl.³ : **G 10 K 11/36, H 03 H 9/145**

(21) Anmeldenummer : **80105480.0**

(22) Anmeldetag : **12.09.80**

(54) **Oberflächenwellen-Bauteil.**

(30) Priorität : **24.09.79 DE 2938542**

(43) Veröffentlichungstag der Anmeldung :
**29.04.81 Patentblatt 81/17**

(45) Bekanntmachung des Hinweises auf die Patenterteilung : **24.08.83 Patentblatt 83/34**

(84) Benannte Vertragsstaaten :
**BE FR GB IT NL**

(56) Entgegenhaltungen :
**US A 3 582 838**
**US A 3 676 721**
**US A 4 035 675**

**JOURNAL OF THE ACOUSTICAL SOCIETY OF
AMERICA, Band 65, Nr. 2, Februar 1979, Seiten
537-540 New York, U.S.A. Y. SHINODA et al. :
« Lamb wave device for amplitude modulation »**

(73) Patentinhaber : **SIEMENS AKTIENGESELLSCHAFT
Berlin und München Wittelsbacherplatz 2
D-8000 München 2 (DE)**

(72) Erfinder : **Grobe, Friedrich
Saarbrücker Strasse 14
D-8000 München 70 (DE)**

EP 0 027 544 B1

Oberflächenwellen-Bauteil

Die Erfindung bezieht sich auf ein Oberflächenwellen-Bauteil nach dem Oberbegriff des Anspruches 1.

Aus dem Stand der Technik sind Oberflächenwellen-Bauteile, insbesondere Oberflächenwellenfilter, bekannt, bei denen in einem auf einem Substratkörper angebrachten (Eingangs-) Wandler piezoelektrisch akustische Oberflächenwellen erzeugt werden, die in der Oberfläche des Substratkörpers verlaufen und in einem (Ausgangs-) Wandler piezoelektrisch wieder in elektrische Ausgangssignale umgewandelt werden. Diese Wandler sind im Regelfall interdigitale Kammstrukturen aus einer Metallisierung der Oberfläche des Substrates. Die einzelnen Finger dieser Kammstrukturen haben eine jeweils gemeinsame Verbindung, die nachfolgend als Rücken oder Rückenteil des Wandlers bezeichnet sind. .

Für die Zuführung des in das Oberflächenwellen-Bauteil einzugebenden elektrischen Signals und für das Abführen des aus dem Oberflächenwellen-Bauteil wieder zu entnehmenden elektrischen Signals sind bisher entsprechende Anschlußleitungen zu den Verbindungsleitungen verwendet worden. Nach dem Stand der Technik sind dafür Drahtzuführungen und Anschlußfahnen verwendet worden, die in einer jeweils geeigneten Weise an den erwähnten Rükkenteilen der Wandler angebracht sind. Es stellte sich stets das Problem, diese Leitungen an diesen Rückenteilen der einzelnen Wandler so anzubringen, daß diese Anbringung keinen auf die Ausbreitung der akustischen Oberflächenwellen störenden Einfluß hat.

Aus der US-PS 3 676 721 ist ein Oberflächenwellen-Bauteil bekannt, das auf seiner einen Oberfläche des Substrates Digitalstrukturen hat. Die Drahtzuführungen und Anschlußfahnen dieser Strukturen befinden sich dort ebenfalls auf derselben Oberfläche des Substrats, auf der sich die jeweilige Struktur befindet. Die für diese Struktur vorgesehene Gegenelektrode befindet sich in einem Abstand über der zugehörigen Struktur d. h. sie ist in einem Abstand von der Oberfläche des Substrates angeordnet. Das im Luftraum oberhalb des Substrates zwischen der Struktur und der Gegenelektrode erzeugte elektrische Feld kann nur deshalb zur Anregung einer Oberflächenwelle im Substrat führen, weil dieses außerhalb des Substrats erzeugte elektrische Feld auch noch etwas in die Oberfläche dieses Substrates hereinwirkt. Auch bei diesem bekannten Oberflächenwellen-Bauteil liegt das Problem störenden Einflusses auf die Ausbreitung der akustischen Oberflächenwelle vor, der durch Anschlüsse bewirkt wird.

Es ist eine Aufgabe der vorliegenden Erfindung, Maßnahmen anzugeben, mit denen das Problem einer geeigneten Signalzuführung bzw. Abnahme von den Wandlern insbesondere im Hinblick auf Verringerung störender Einflüsse auf die Wellenausbreitung verbessert werden kann.

Diese Aufgabe wird für ein Oberflächenwellen-Bauteil nach dem Oberbegriff des Anspruches 1 gemäß den Merkmalen des Kennzeichens des Anspruches 1 gelöst. Weitere Ausgestaltungen und Weiterbildungen der Erfindung gehen aus den Unteransprüchen hervor.

Grundlage der Erfindung ist dis Erkenntnis, daß an den Wandlern anzubringenede galvanische Zuführungen höchstens unter nicht mehr zu vertretendem technischen Aufwand diesbezüglich irgendwie weiter verbessert werden könnten. Die Erfindung geht daher von der ganz anderen Überlegung aus, die Signalzuführung und -abnahme auf kapazitivem oder induktivem Wege zu erreichen, und zwar durch solche Kapazitäten und Induktivitäten, die in einer Art integrierter Bauweise am Substratkörper selbst realisiert sind.

Gemäß einer Ausführungsform bildet das Material des Substratkörpers das Dielektrikum einer jeweiligen Kopplungskapazität, zu der das relativ breite Rückenteil der jeweiligen Kammelektrode des auf der vorderen Oberfläche des Substratkörpers angebrachten Wandlers die eine Elektrode bildet und eine dieser Elektrode gegenüberliegende Elektrodenbelegung im Bereich der Rückseite des Substrates die andere Elektrode bildet.

Für eine Ausführungsform mit induktiver Übertragung ist auf der Vorderseite des Substratkörpers eine die beiden Kammelektroden des jeweiligen Wandlers miteinander elektrisch verbindende Koppelschleife vorgesehen. Eine ebensolche jeweils zweite Koppelschleife ist im Bereich der gegenüberliegenden Unterseite des Substratkörpers vorhanden.

Für beide voranstehend beschriebenen Ausführungsformen sind galvanische Zuführungsleitungen vorgesehen, die hier bei der Erfindung jedoch für die erste Ausführungsform an der jeweiligen Elektrode im Bereich der Rückseite des Substrates bzw. für die andere Ausführungsform an der im Bereich der Rückseite des Substrates befindlichen Koppelschleife angeschlossen sind. Eine die Ausbreitung der Oberflächenwellen störende Beeinflussung dieser Anschlüsse der Verbindungsleitungen tritt nicht auf, da die sich auf der Oberfläche des Substrates zwischen den Eingangs- und Ausgangswandlern ausbreitende Oberflächenwelle keine derart weit in das Substrat und erst recht nicht bis unterhalb des Substrates reichende wirkung hat.

Mit der Erfindung wird direkt oder indirekt eine Reihe von Vorteilen erreicht. Für die Anbringung der Anschlüsse auf den nunmehr unterhalb der Rückseite des Substrates befindlichen Elektroden bzw. Koppelschleifen ist weit weniger technischer Aufwand erforderlich, als dies für einen bekannten Drahtanschluß auf der Vorderseite notwendig wäre. Für das bei dem Stand der Technik vorgesehenen Anschliessen der Zuführungsdrähte an die Anschlußfahnen der Wandler sind Maßnahmen wie Aufheizen und Plattierung der Anschlußfahnen sowie ein erhebliches Mindestmaß für die Dicke des Substrates erforderlich. Solche Maßnahmen können bei der Erfindung entfallen ; insbesondere kann das Substrat relativ dünn gehalten werden. Bei der Erfindung sind darüber hinaus auch keine wie im Stand der Technik in Einzelfällen verwendete Trennkondensatoren zum Fernhalten von Gleichspannungen von dem Oberflächenwellen-Bauteil erforderlich.

Weitere Erläuterungen der Erfindung gehen aus der nachfolgenden Beschreibung von Ausführungsbeispielen hervor.

Figuren 1 bis 3 zeigen eine Aufsicht und zwei Seitenansichten einer Ausführungsform mit kapazitiver Kopplung und

Figuren 4 und 5 zeigen Aufsicht und Seitenansicht einer Ausführungsform mit induktiver Kopplung.

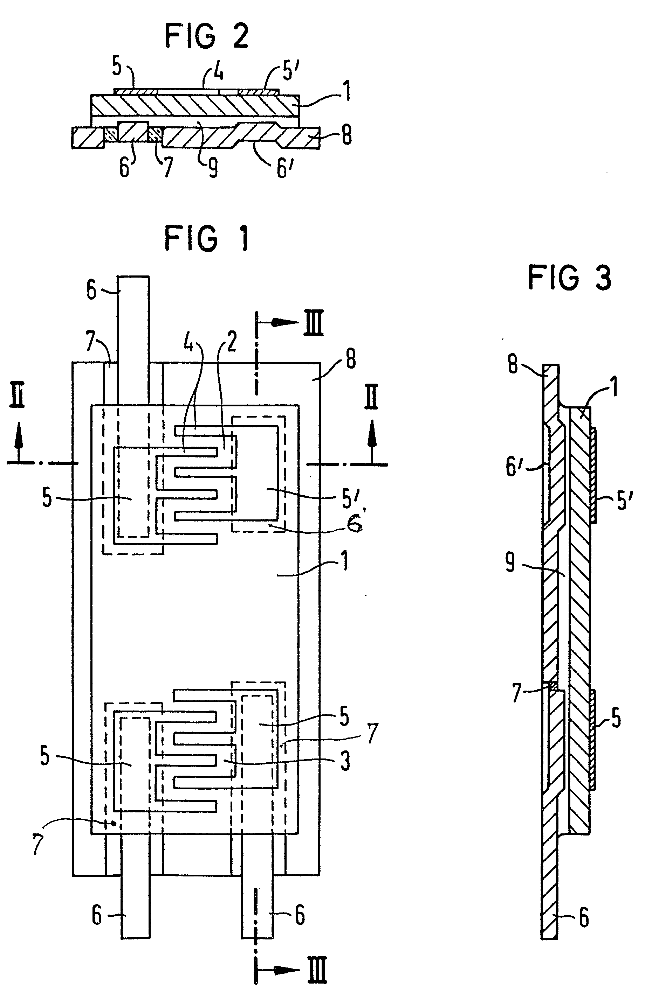

In den Fig. 1 bis 3 sind mit 1 der Substratkörper des Bauteils, z. B. aus einkristallinem Lithiumniobat, bezeichnet. Mit 2 und 3 sind ganze interdigitale Wandler-Kammstrukturen bezeichnet, die als Eingangs- und als Ausgangswandler dienen. Solche bekannten Wandlerstrukturen 2 und 3 bestehen aus ineinandergreifenden Fingern 4, die aufeinanderfolgend abwechselnd mit den als Verbindungen wirkenden Rückenteilen 5 bzw. 5′ verbunden sind. Diese Wandler 2 und 3 bzw. die Elektrodenfinger 4 und die Rückenteile 5 und 5′ sind z. B. auf die Vorderseite des Substrates 1 nach bekannten fotolithografischen Verfahren aufgebrachte Metallschichten außerordentlich geringer Dicke.

Mit 8 ist eine wie im Stand der Technik verwendete Grundplatte bezeichnet, auf der in bekannter Weise das Substrat 1 mit einem auch als Dämpfungsmaterial wirkenden Kitt 9 aufgebracht ist.

Mit 6 sind einzelne Anschlußfahnen bezeichnet, die in einfachster Weise die jeweilige Gegenelektrode zum zugehörigen, auf der Oberseite des Substrates 1 gegenüberliegenden Rückenteil 5 der jeweiligen Kammstruktur bilden. Die Schichtdicke des Kittes 9 zwischen der jeweiligen Anschlußfahne 6 und der Rückseite des Substrates 1 wird möglichst gering gehalten. Mit 7 sind elektrische Isolationen bezeichnet, mit denen die jeweilige Anschlußfahne 6 gegenüber der metallischen Grundplatte 8 mechanisch gehalten, jedoch elektrisch isoliert ist.

Wie den Fig. 1 bis 3 zu entnehmen ist, ist hier für das Rückenteil 5′ keine besondere Anschlußfahne 6 (vergleichsweise zum Rückenteil 5) vorgesehen. Für das Rückenteil 5′ wirkt bereits die Grundplatte 8, die an Masse angeschlossen ist, als eine solche Gegenelektrode. Für die Wandlerstruktur 2 liegt damit jedoch ein unsymmetrischer Eingang vor. Vorteilhafterweise ist der mit 6′ hervorgehobene Anteil der Grundplatte 8 in wie dargestellter Weise nach oben geprägt, so daß zwischen dem Anteil 6′ und der Rückseite des Substrates 1 und damit zwischen 6′ und dem darüber befindlichen Rückenteil 5′ ein vergleichsweise verringerter Abstand, und zwar zur Erhöhung der Kapazität zum Rückenteil 5′, vorhanden ist. Es ist dabei zu berücksichtigen, daß die Dicke der Kittschicht wegen deren geringer Dielektrizitätskonstante vergleichsweise stärker eingeht.

Der symmetrisch geschaltete Wandler 3 besitzt je eine Anschlußfahne 6 für ein jedes Rückenteil 5.

Nachfolgend werden Zahlenangaben zu Bemessungen einer Ausführungsform nach den Fig. 1 bis 3 gemacht. Als Substrat ist Lithiumniobat mit einer Dielektrizitätskonstanten von 50 verwendet. Die Dicke des Substrates beträgt beispielsweise 0,3 mm. Die effektive Kapazität $C_W$ eines einzelnen Wandlers beträgt etwa 5 pF bei einer Länge des Wandlers, d. h. bei einer Länge des Rückenteils 5 von 4 mm.

Für die Dicke des als Kitt 9 verwendeten Films mit einer Dielektrizitätskonstanten von angenommenerweise 5 liegt ein Wert von ca. 0,003 mm vor. Bei solchen Abmessungen läßt sich eine Koppelkapazität $C_K$ zwischen einer Anschlußfahne bzw. dem Anteil 6′ der Grundplatte 8 einerseits und dem Rückenteil 5 bzw. 5′ des einzelnen Wandlers 2, 3 von etwa 9 pF erreichen, wenn bei der Länge von 4 mm die Breite des Rückens und der Anschlußfahne etwa 2 mm groß gemacht wird, so daß die entstandene Kondensatorfläche etwa 7 mm² ist.

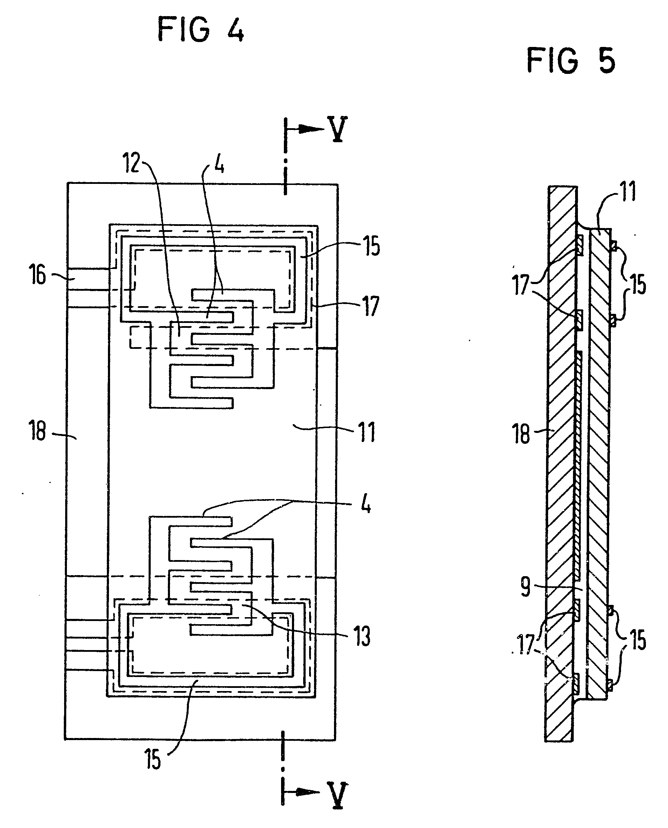

Die in den Fig. 4 und 5 gezeigte Ausführungsform mit induktiver Kopplung weist zu einem großen Anteil prinzipiell gleiche Einzelheiten wie die Ausführungsform der Fig. 1 bis 3 auf. Mit 11 ist hier der Substratkörper bezeichnet, der sich auf der Grundplatte 18 befindet. Die Grundplatte 18 ist hier in einer bekannten Schichttechnik ausgeführt. Mit 12 und 13 sind zwei Wandlerstrukturen bezeichnet, die wiederum Wandlerfinger 4 haben. Mit 15 ist je eine der auf der Vorderseite des Substrates 11 aufgebrachten Leiterschleifen bezeichnet, die mit ihren beiden Anschlußenden, wie aus der Fig. 4 ersichtlich, mit den jeweiligen Teilen der Wandlerstrukturen 12 und 13 verbunden sind. Mit 17 sind die im Bereich der Rückseite des Substrates 11 auf der Grundplatte vorgesehenen Leiterschleifen bezeichnet, die mit den ihnen jeweils gegenüberliegenden Leiterschleifen 15 induktiv gekoppelt sind. Mit 16 ist eine dargestellte, nach außen geführte Anschlußleitung des einen Endes der Leiterschleifen 17 bezeichnet. Das andere Ende der Leiterschleifen 17 ist mit dem Massebelag der Grundplatte 18 entsprechend einem unsymmetrischen Eingang verbunden.

**Ansprüche**

1. Oberflächenwellen-Bauteil mit auf der Vorderseite eines Substrates (1 ; 11) angeordneten interdigitalen Wandlerstrukturen (2, 3 ; 12, 13), die Rückenteile zur Verbindung ihrer Wandlerfinger miteinander haben, wobei das Substrat auf einer Grundplatte (8 ; 18) angebracht ist, gekennzeichnet dadurch, daß für einen störungsfreien Anschluß der Wandlerstrukturen (2, 3 ; 12, 13) kapazitive oder induktive Kopplung zwischen der jeweiligen Wandlerstruktur (2, 3) und Elektroden (6, 6') bzw. zwischen einer die Rückenteile jeweils einer Wandlerstruktur (12, 13) verbindenden Leiterschleife (15) auf der Oberseite des Substrates (11) und einer weiteren Leiterschleife (17) vorgesehen ist, wobei diese Elektroden (6, 6') bzw. die weitere Leiterschleife (17) im Bereich der Rückseite des Substrates (1, 11) angeordnet sind (ist) und wobei diese Elektroden (6, 6') bzw. die weitere Leiterschleife (17) den jeweiligen Rückenteilen (5, 5') bzw. der jeweiligen Leiterschleife (15) auf der Vorderseite in bezug auf das Substrat (11) gegenüberliegend angeordnet sind.

2. Oberflächenwellen-Bauteil nach Anspruch 1, gekennzeichnet dadurch, daß wenigstens eine der im Bereich der Rückseite des Substrates (1) vorgesehenen Elektroden eine Anschlußfahne (6) ist, die bis wenigstens nahe an die Rückseite des Substrates heranreichend elektrisch isoliert in die Grundplatte (8) eingebettet ist (Fig. 1 bis 3).

3. Oberflächenwellen-Bauteil nach Anspruch 1 oder 2, gekennzeichnet dadurch, daß wenigstens eine der im Bereich der Rückseite des Substrates (1) vorgesehenen Elektroden ein Anteil (6') der Grundplatte (8) ist, der bis wenigstens nahe der Rückseite des Substrates (1) vorspringend ist.

## Claims

1. A surface wave component having interdigital transducer structures (2, 3 ; 12, 13) which are arranged on the front face of a substrate (1 ; 11) and which have rear portions for the interconnection of their transducer fingers, the substrate being mounted on a base plate (8 ; 18), characterised in that in order to provide a distortion-free connection of the transducer structures (2, 3 ; 12, 13), capacitive or inductive coupling is provided between the particular transducer structure (2, 3) and electrodes (6, 6'), or between a conductive loop (15) which connects the rear portions of one transducer structure (12, 13) on the upper side of the substrate (11), and a further conductor loop (17), the electrodes (6, 6') or the further conductor loop (17), as the case may be, being arranged in the region of the rear face of the substrate (1, 11), and the electrodes (6, 6'), or the further conductor loop (17), as the case may be, being arranged opposite to the rear portions (5, 5') or the conductor loop (15), as the case may be, on the front face of the substrate (11).

2. A surface wave component according to Claim 1, characterised in that at least one of the electrodes arranged in the region of the rear face of the substrate (1) is a connecting lug (6) extending at least close to the rear face of the substrate and which is embedded in the base plate (8) in electrically insulated manner (Fig. 1 to 3).

3. A surface wave component according to Claim 1 or Claim 2, characterised in that at least one of the electrodes arranged in the region of the rear side of the substrate (1) is a part (6') of the base plate (8) which is arranged to project to at least close to the rear face of the substrate (1).

## Revendications

1. Dispositif à ondes acoustiques de surface avec des structures de transducteurs interdigitées (2, 3 ; 12, 13) disposées sur le côté frontal d'un substrat (1 ; 11), et qui possèdent des parties dorsales pour relier entre eux les doigts de leurs transducteurs, le substrat étant monté sur une plaque de base (8 ; 18), caractérisé par le fait que pour un branchement, sans perturbations, des structures de transducteurs (2, 3 ; 12, 13) il est prévu un couplage capacitif ou inductif entre la structure de transducteur concernée (2, 3) et les électrodes (6, 6') ou entre une boucle conductrice (15) disposée sur le côté supérieur du substrat (11) et reliant la partie dorsale d'une structure de transducteur concernée (12, 13) et une autre boucle conductrice (17), ces électrodes (6, 6') ou ladite autre boucle conductrice (17) étant disposées (ou disposée) sur le côté dorsal du substrat (1, 11) et ces électrodes (6, 6') ou ladite autre boucle conductrice (17) étant associées, en position opposée par rapport au substrat, aux éléments dorsaux respectifs (5, 5') ou aux boucles conductrices (15).

2. Dispositif à ondes acoustiques de surface selon la revendication 1, caractérisé par le fait qu'au moins l'une des électrodes prévues sur le côté dorsal du substrat (1) est pourvue d'une languette de branchement (6) qui, tout en étant isolée électriquement sur une distance qui s'étend au moins jusqu'au voisinage du côté dorsal du substrat, est noyée dans la plaque de base (8) (figures 1 à 3).

3. Dispositif à ondes acoustiques de surface selon la revendication 1 ou 2, caractérisé par le fait qu'au moins l'une des électrodes prévues dans la zone du côté dorsal du substrat (1), est une partie de la plaque de base (8), qui est saillante au moins jusqu'au voisinage du côté postérieur du substrat (1).

0 027 544

FIG 2

FIG 1

FIG 3

1

FIG 4

FIG 5